# EUROPEAN PATENT SPECIFICATION

(11) **EP 0 510 869 B1**
(45) Date of publication and mention of the grant of the patent: **03.07.1996**
(21) Application number: 92303386.4
(22) Date of filing: 15.04.1992
(51) Int. Cl.: H01R 23/70, H01R 23/68

(54) **Electrical connector having terminals which cooperate with the edge of a circuit board**
Elektrischer Verbinder mit Anschlüssen, welche mit dem Rand einer Leiterplatte zusammenwirken
Connecteur électrique avec bornes coopérant avec la bordure de caste à circuit imprimé

(30) Priority: 26.04.1991 US 692084
(43) Date of publication of application: 28.10.1992
(73) Proprietor: THE WHITAKER CORPORATION, Wilmington, Delaware 19808 (US)
(72) Inventor: Korsunsky, Iosif, Harrisburg, Pennsylvania 17110 (US); Grabbe, Dimitry, Middletown, Pennsylvania 17057 (US)
(74) Representative: Warren, Keith Stanley

(56) References cited:
- EP-A- 0 254 385
- EP-A- 0 417 899
- DE-U- 8 908 718
- US-A- 4 223 968

## Description

The invention is directed to an electrical connector which is mounted on a printed circuit board. In particular the invention relates to an electrical connector which has surface mount terminals and through-hole mounted terminals which extend from a mating surface thereof.

There are currently numerous electrical connectors available which are mounted to a printed circuit board. As the size of the machines in which the printed circuit boards are installed decreases, the density of the connectors positioned on the board must increase. Also, as the machines become more sophisticated, the complexity of the printed circuit boards and the connectors must increase. Consequently, the configuration of the machines requires that electrical connectors with numerous terminals extending therefrom be mounted on a printed circuit board in such a manner so as to occupy a minimal area of board real estate.

In the early stages of the progression toward high density placement of the connectors, through-hole mounting technology was used. Mating portions of the terminals were placed in through-holes of the circuit board and held in place by soldering or some type of mechanical engagement of the pin with the sidewalls of the hole. As the need for high density increased, the amount of through-holes required also increased. However, as the diameter of the through holes is relatively large, only a fixed number of through-holes could be provided in a given area. Consequently, through-hole technology could not support the requirements for high density applications.

In order to provide for a higher density of connectors on the board, surface mount technology was utilized. As no through-holes were required, the conductive pads on the circuit board could be closely spaced, thereby allowing more contacts to be mounted in the same are of the board. Also, as the terminals were configured to be surface mounted to the printed circuit board, the terminals were designed to have resilient characteristics which allowed the terminals to compensate for board warpage and the like, thereby insuring for a more reliable interconnection.

It is also important to realise that as the density of the connectors increases, the length of the terminals cannot increase significantly. Particularly in high speed applications, the ideal solution is one which provides high density connectors which have the shortest path over which the signals must travel.

As the progression towards higher density continues, it has become imperative that every possible area of board real estate be utilized. Consequently, the invention described herein is directed to an electrical connector which can be mounted to the edge of a printed circuit board. This type of connector requires the use of both surface mount and through-hole mount technology.

According to one aspect thereof the present invention consists in a connector assembly as defined in claim 1.

According to another aspect thereof the present invention consists in a connector assembly as defined in claim 9.

EP-A-0 254 385 discloses a connector assembly according to the preambles of claims 1 and 9.

DE-U-89 08 718 discloses an electrical connection between a rigid conductive plate and a flat flexible circuit. An edge portion of the flexible circuit is glued into an opening in an edge of the rigid plate and is engaged with a connecting contact in the opening.

There is disclosed herein a method of providing an electrical connection between an electrical connector and an edge surface of a substrate. In order to accomplish this, pins of the electrical connector are inserted into the edge surface of the substrate, thereby positioning the pins of the electrical connector in an opening of the substrate.

As disclosed herein, the connector assembly has a housing with first and second terminals extending therefrom. The first and second terminals have respectively first and second mounting portions which cooperate with a printed circuit board provided proximate the housing. The printed circuit board has conductive areas provided on surfaces thereof and conductive openings which extend between the surfaces.

The first terminals are secured in the housing, with first securing portions of the first terminals provided in first terminal receiving cavities. The first mounting portions are integral with the first securing portions and extend outside the housing, thereby allowing the first mounting portions to cooperate with the conductive areas provided on the printed circuit board. The second terminals are also secured in the housing, with second securing portions of the second terminals provided in second terminal receiving cavities. The second mounting portions are integral with the second securing portions and extend outside the housing, thereby allowing the second mounting portions to cooperate with the conductive openings provided on the printed circuit board.

The conductive openings of the printed circuit board are positioned proximate an edge surface of the printed circuit board. The second mounting portions have lead-in surfaces provided at free ends thereof. The lead-in surfaces cooperate with the edge surface of the substrate to allow the second mounting portions to be inserted through the edge surface into the openings of the substrate.

Apertures may be provided in the edge surfaces of the printed circuit board. The apertures extend in a direction which is essentially perpendicular to the axis of the conductive openings, and are dimensioned to receive the second mounting portions of the second terminals therein, such that the second terminals extend through the apertures into the conductive openings.

An embodiment of the invention will now be described by way of example with reference to the accompanying drawings in which:
FIGURE 1 is a perspective view of a connector assembly which provides an electrical connection between sides of a first printed circuit board and a surface of a second printed circuit board;
FIGURE 2 is an exploded perspective view of the connector assembly of Figure 1, showing a first connector housing and a second connector housing, with a bus bar provided therebetween;
FIGURE 3 is a partial cross-sectional view of the connector housings shown in Figure 2, the bus bar of Figure 2 is positioned in the first connector housing;
FIGURE 4 is a partial cross-sectional view of the connector housings, similar to that shown in Figure 3, with the connector housings mated together;
FIGURE 5 is a cross-sectional view of the connector housings prior to connector housings being mated with each other;
FIGURE 6 is a cross-sectional view of the connector housings, similar to that of Figure 5, showing the connector housings in a mated condition;
FIGURE 7 is a cross-sectional view of the connector housings, taken in a different plane than the cross-sectional view of Figure 6, showing the connector housings in a mated condition;
FIGURE 8 is a top perspective view of the first connector housing, before the first connector housing has been positioned on the edge of the first printed circuit board;
FIGURE 9 is a bottom perspective view of the first connector housing, before the first connector housing has been positioned on the edge of the first printed circuit board;
FIGURE 10 is a top perspective view of the second connector housing with several terminals exploded therefrom, before the second connector housing has been positioned on the surface of the second printed circuit board;
FIGURE 11 is a bottom perspective view of the second connector housing, before the second connector housing has been positioned on the surface of the second printed circuit board;
FIGURE 12 is a perspective view of a retention member which can be inserted into an opening of the first printed circuit board;
FIGURE 13 is an enlarged cross-sectional view of a respective opening of the first printed circuit board with the retention member and a terminal of the first connector housing position therein;
FIGURE 14 is a perspective view of an alternative retention member which can be inserted into an opening of the first printed circuit board;
FIGURE 15 is an top plan view of a respective opening of the first printed circuit board with the alternative retention member inserted therein;
FIGURE 16 is a cross-sectional view of the respective opening of the first printed circuit board with the alternative retention member and a terminal of the first connector housing position therein;
FIGURE 17 is a perspective view of the first printed circuit board illustrating the positioning of the retention member and the alternative retention member in the openings of the first printed circuit board;
FIGURE 18 is an enlarged cross-sectional view of showing an alternate embodiment of a terminal inserted into the opening of the printed circuit board; and
FIGURE 19 is a cross-sectional view of an alternative embodiment of a connector housing.

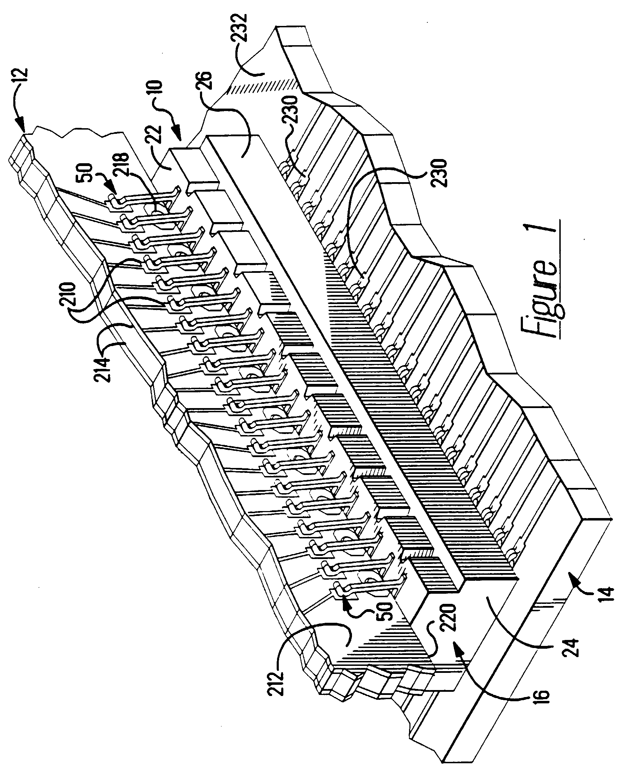

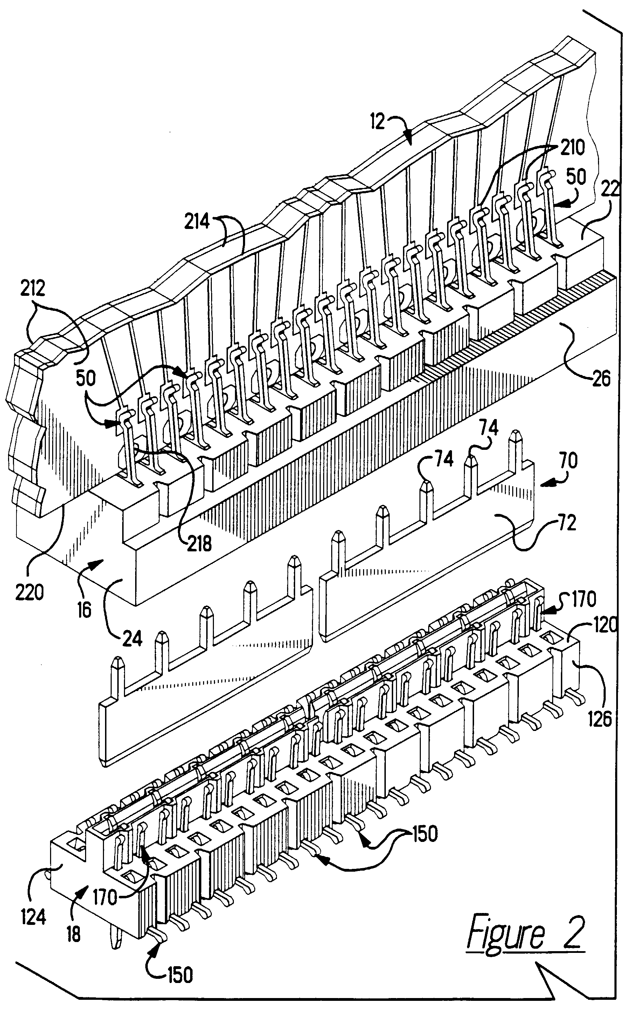

Referring to Figure 1, an electrical connector assembly 10 is shown which is used to provide the electrical connection between a first circuit board 12 and a second circuit board 14. The connector assembly 10 has a first connector housing 16 and a second connector housing 18, as best shown in Figure 2.

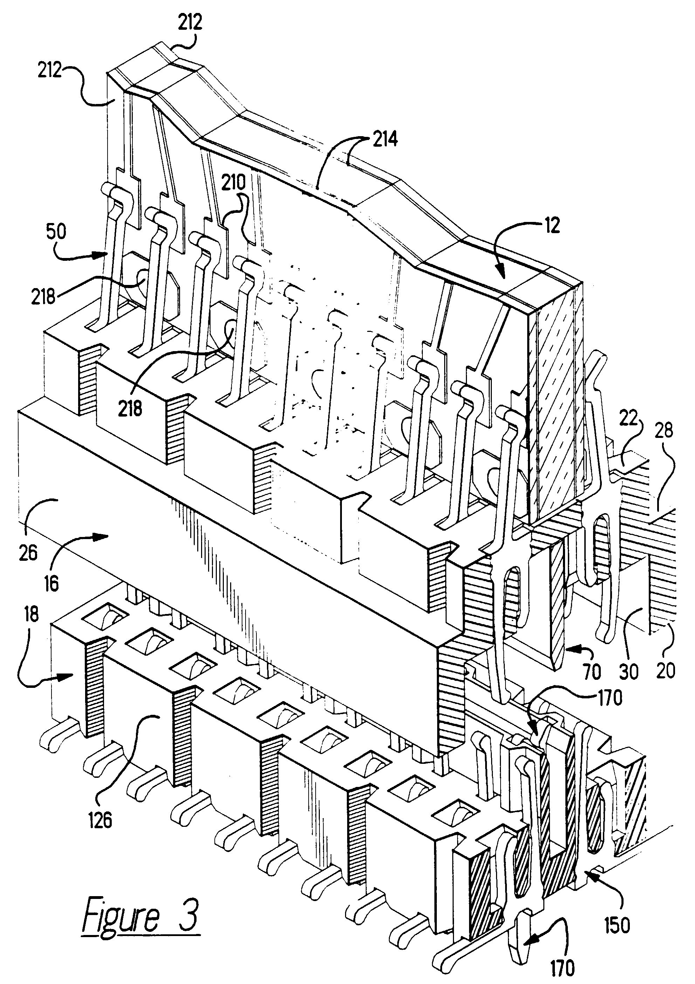

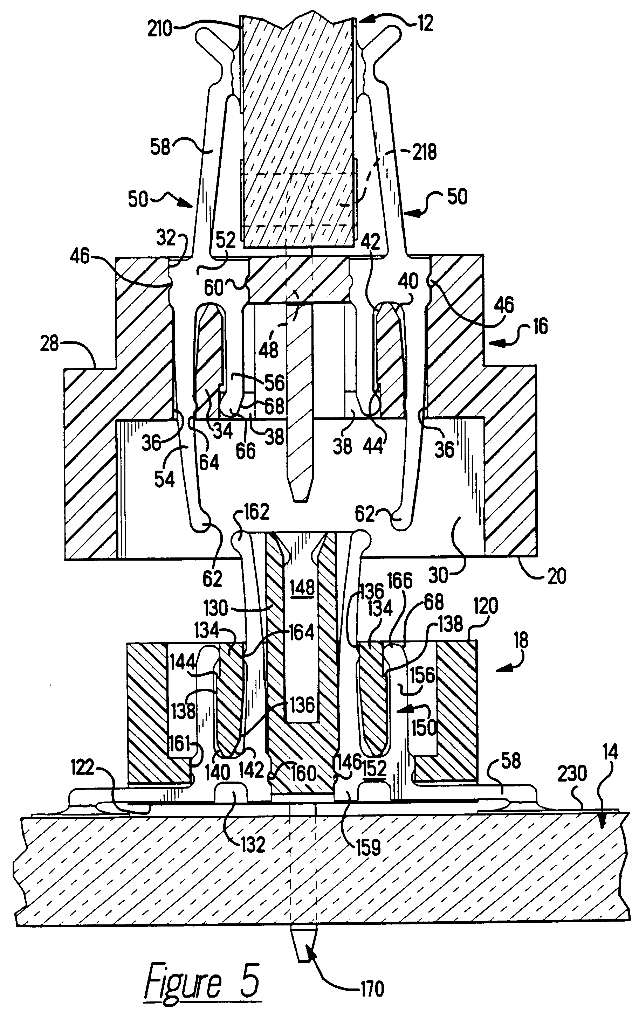

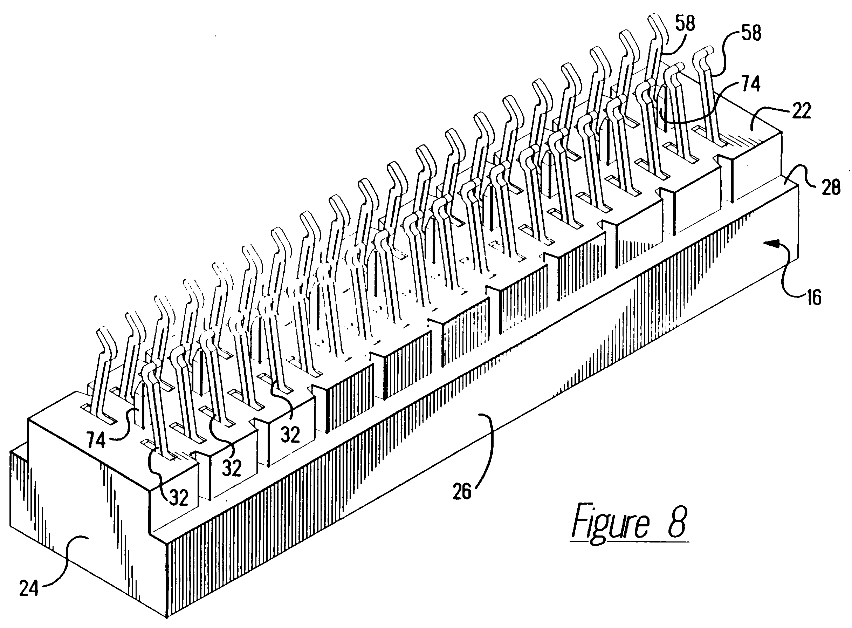

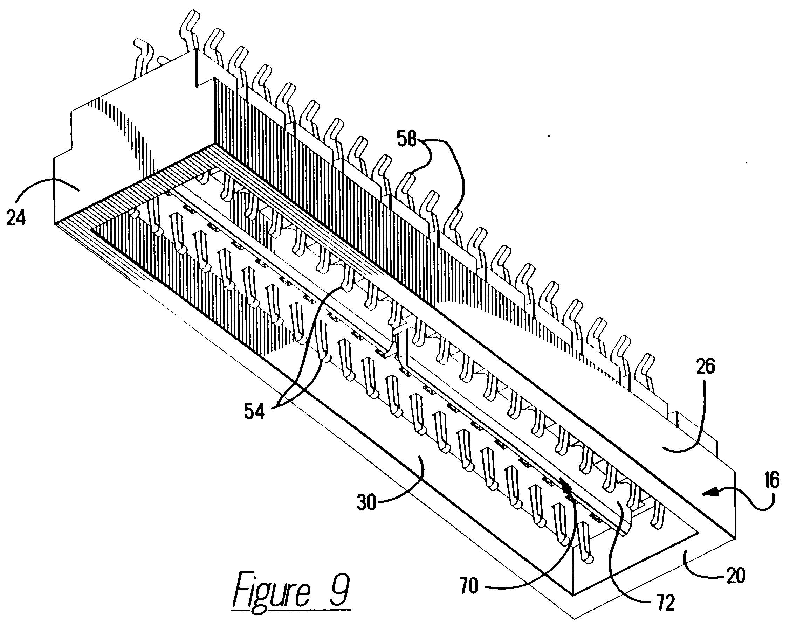

The first connector housing 16 is best shown in Figures 2 through 9. Referring to Figures 3 and 5, the first connector housing 16 has a first or mating surface 20 and an oppositely facing second or terminal receiving surface 22. End walls 24 (Figures 8 and 9) and side walls 26 extend between the mating surface 20 and the terminal receiving surface 22. The side walls 26 have transition portions 28 provided thereon, as the mating surface 20 is larger than the terminal receiving surface 22.

A mating connector receiving recess 30 extends from the mating surface 20 toward the terminal receiving surface 22. The mating connector receiving recess 30, as best shown in Figure 9, is dimensioned to be positioned proximate the end walls 24 and proximate the side walls 26.

Terminal receiving cavities 32 are provided in the first connector housing 16 and extend from the terminal receiving surface 22 to the mating connector receiving recess 30. As best shown in Figure 5, the terminal receiving cavities 32 are provided on both sides of the longitudinal axis of the first connector housing 16. The terminal receiving cavities 32 provided on a respective side of the axis are mirror images of the terminal receiving cavities provided on the opposite side of the axis. Referring to Figure 5, the terminal receiving cavities 32 have dividing walls 34 which separate the terminal receiving cavities into two portions, first leg receiving cavities 36 and second leg receiving cavities 38. The dividing walls 34 have lead-in surfaces 40, 42 which are provided proximate the terminal receiving surface 22. Shoulders 44 are provided on the dividing walls 34 on surfaces of the dividing walls which are positioned proximate the second leg receiving cavities 38. Securing projections 46 are also provided in the terminal receiving cavities 32.

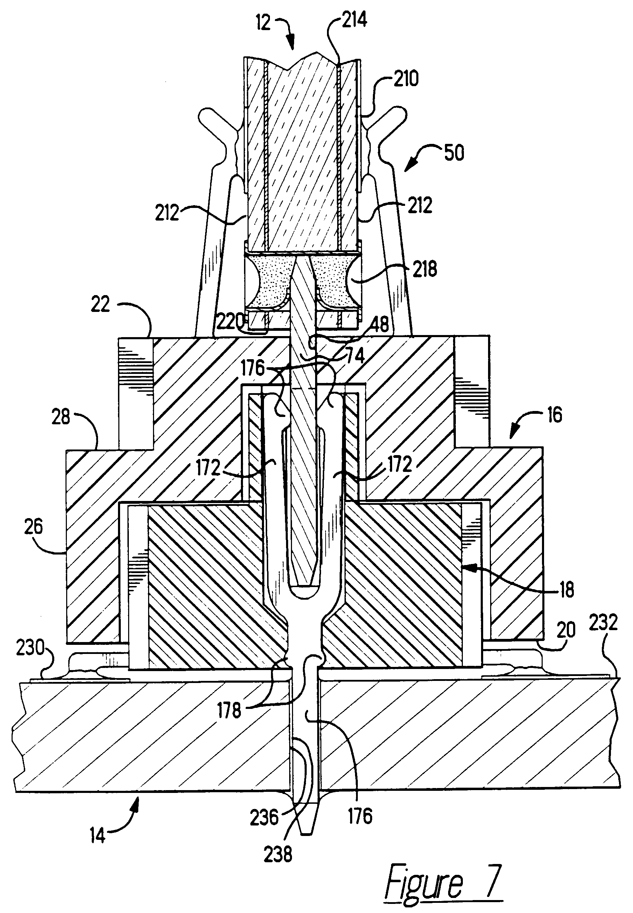

Bus bar receiving recesses 48, as best shown in Figures 5 and 7, are provided in the first connector housing 16. The bus bar receiving recesses 48 extend from the mating connector receiving recess 30 to the terminal receiving surface 22.

First connector terminals 50, as best shown in Figure 5, have mounting portions 52. First legs 54 and second legs 56 extend from the mounting portions 52 in essentially the same direction, thereby enabling the first and the second legs 54, 56 to be mated with the mating connector, as will be more fully discussed. Printed circuit board mating legs 58 extend from the mounting portions 52 in a direction which is opposed to the first and second legs 54, 56.

The mounting portions 52 have recesses 60 provided on side surfaces thereof. The recesses 60 cooperate with the securing projections 46 to provide the interference fit required to maintain the terminals 50 in the terminal receiving cavities 32. It should be noted that end surfaces of the dividing walls 34 also cooperate with surfaces of the mounting portions 52 to ensure that the terminals 50 are properly positioned.

First legs 54 have a slightly arcuate configuration. Free ends of the first legs have enlarged contact sections 62 which extend beyond the first leg receiving cavities 36 and into the mating connector receiving recess 30. Enlarged positioning sections 64 are also provided on the first legs 54. The positioning sections 64 cooperate with the dividing walls 34 when the first legs are in an unmated condition. It is important to note that the first leg receiving cavities 36 are dimensioned to allow the first legs 54 to move therein, thereby allowing the first legs to move from an unmated or slightly prestressed position to a mated position.

Second legs 56 are positioned in the second leg receiving cavities 38. Unlike the first legs, the second legs 56 do not extend into the mating connector receiving recess 30. Free ends 66 of the second legs are provided at an angle relative to the second legs. This allows the free ends 66 to engage the dividing walls 34, as shown in Figure 5. Lead-in surfaces 68 are provided at the free ends 66 of the second legs 56.

Referring to Figures 2 and 7, bus bars 70 are positioned in the first connector housing 16 (as best shown in Figures 7 and 9). The bus bars 70 have connector mating portions 72 and circuit board mating pins 74. The circuit board mating pins 74, as shown in Figure 7, are positioned in the bus bar receiving recesses 48. The connector mating portions extend from the bus bar receiving recesses 48 into the mating connector receiving recess 30.

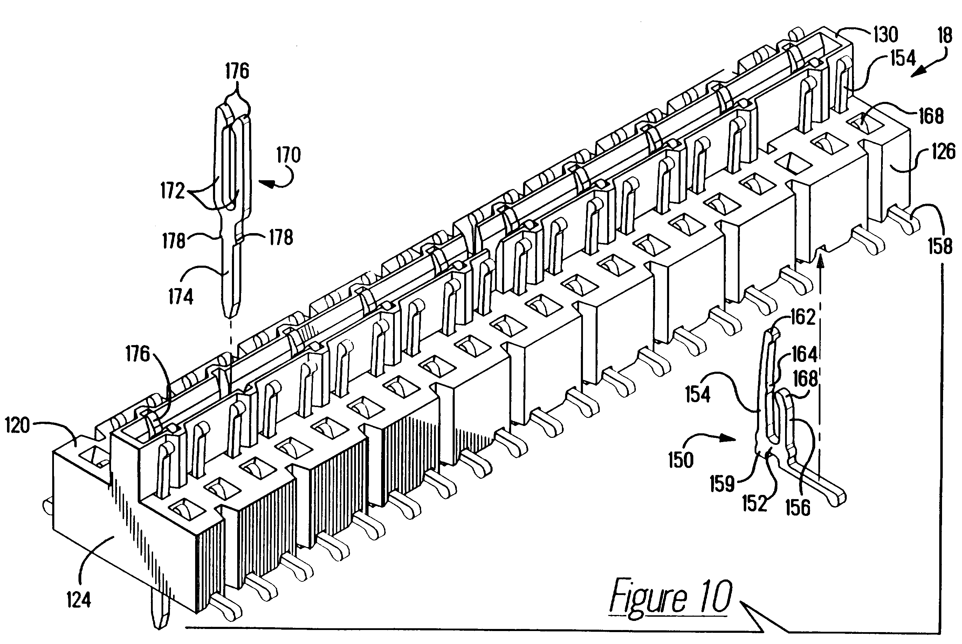

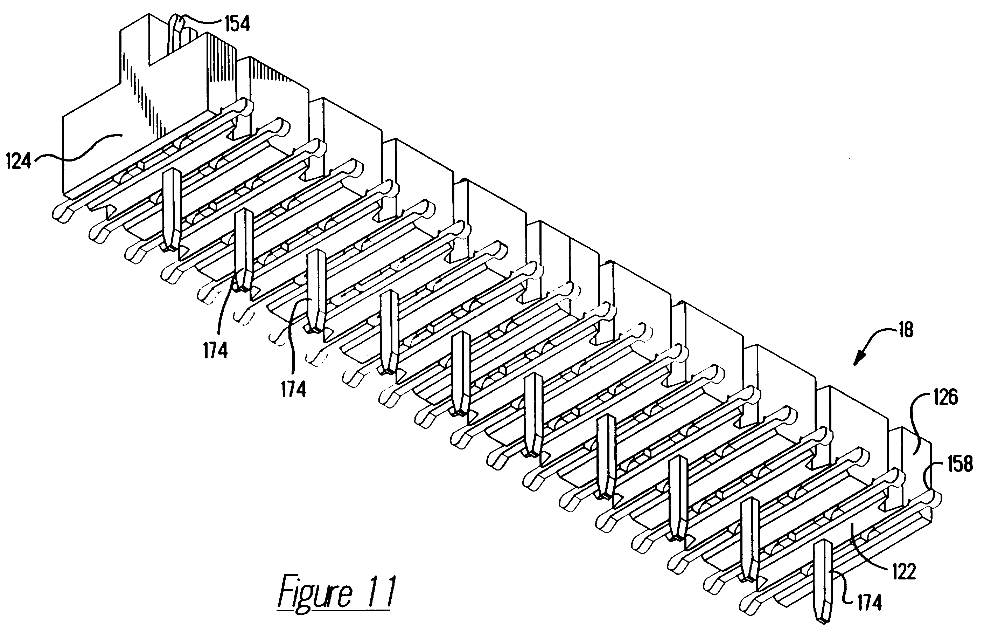

The second connector housing 18 is best shown in Figures 2 through 7 and 10 through 11. Referring to Figures 3 and 5, the second connector housing 18 has a first or mating surface 120 and an oppositely facing second or terminal receiving surface 122. End walls 124 (Figures 10 and 11) and side walls 126 extend between the mating surface 120 and the terminal receiving surface 122.

A mating projection 130 extends from the mating surface 120 away from the terminal receiving surface 122. The mating projection 130, as best shown in Figure 10, is dimensioned to extend between the end walls 124.

Terminal receiving cavities 132 are provided in the second connector housing 18 and extend from the terminal receiving surface 122 to the mating surface 120. As best shown in Figure 5, the terminal receiving cavities 132 are provided on both sides of the longitudinal axis of the second connector housing 18. The terminal receiving cavities 132 provided on a respective side of the axis are mirror images of the terminal receiving cavities provided on the opposite side of the axis. Referring to Figure 5, the terminal receiving cavities 132 have dividing walls 134 which separate the terminal receiving cavities into two portions, first leg receiving cavities 136 and second leg receiving cavities 138. The dividing walls 134 have lead-in surfaces 140, 142 which are provided proximate the terminal receiving surface 122. Shoulders 144 are provided on the dividing walls 134 on surfaces of the dividing walls which are positioned proximate the second leg receiving cavities 138. Securing projections 146 are also provided in the terminal receiving cavities 132.

Bus bar receiving recess 148, as best shown in Figures 5 and 7, is provided in the second connector housing 18. The bus bar receiving recess 148 extends from the terminal receiving surface 122 past the mating surface 120 through the mating projection 130.

Second connector terminals 150, as best shown in Figure 5, have mounting portions 152. First legs 154 and second legs 156 extend from the mounting portions 152 in essentially the same direction, thereby enabling the first and the second legs 154, 156 to be mated with the mating connector, as will be more fully discussed. Printed circuit board mating legs 158 and stand off legs 159 extend from the mounting portions 152 in a direction which is opposed to the first and second legs 154, 156.

The mounting portions 152 have recesses 160 provided on side surfaces thereof. The recesses 160 cooperate with the securing projections 146 to provide the interference fit required to maintain the terminals 150 in the terminal receiving cavities 132. Terminals 150 have projections 161 which extend from side surfaces thereof. The projections 161 facilitate the interference fit of the terminals. It should be noted that end surfaces of the dividing walls 134 also cooperate with surfaces of the mounting portions 152 to ensure that the terminals 150 are properly positioned.

First legs 154 have a slightly arcuate configuration. Free ends of the first legs have enlarged contact sections 162 which extend beyond the first leg receiving cavities 136 and beyond the mating surface 120. Enlarged positioning sections 164 are also provided on the first legs 154. The positioning sections 164 cooperate with the dividing walls 134 when the first legs are in an unmated condition. It is important to note that the first leg receiving cavities 136 are dimensioned to allow the first legs 154 to move therein, thereby allowing the first legs to move from an unmated or slightly prestressed position to a mated position.

Second legs 156 are positioned in the second leg receiving cavities 138. Unlike the first legs, the second legs 156 do not extend beyond the mating surface 120. Free ends 166 of the second legs are provided at an angle relative to the second legs. This allows the free ends 166 to engage the dividing walls 134, as shown in Figure 5. Lead-in surfaces 168 are provided at the free ends 166 of the second legs 156.

Referring to Figures 7 and 10, bus bar mating terminals 170 are positioned in the second connector housing 18. The bus bar mating terminals 170 have connector mating portions 172 and circuit board mating pins 174. The connector mating portions 172 have an essentially U-shaped configuration, with enlarged contact projections 176 provided at the free ends thereof. The circuit board mating pins 174 have enlarged securing projections 178 which cooperate with the side walls of the receiving recess 148 to maintain the bus bar mating terminals 170 in the recess.

The first printed circuit board 12, as best shown in Figures 1 through 4, has conductive signal paths 210 provided on the opposing side surfaces 212 thereof. Conductive grounding planes 214 are positioned below the side surfaces 212, as shown in Figure 3. The conductive grounding planes 214 are provided in electrical engagement with conductive side walls 216 of openings 218. The particular configuration of the first printed circuit board 12 has the openings 218 provided proximate edge surface 220 of the circuit board.

The second printed circuit board 14, as shown in Figures 1 and 7, has conductive signal paths 230 provided on at least on surface 232 thereof. Conductive grounding planes (not shown) are positioned below the surface 232. The conductive grounding planes are provided in electrical engagement with conductive side walls 236 (Figure 7) of openings 238.

In operation, the first connector housing 16 is positioned in electrical engagement with the first printed circuit board 12. In order to accomplish this electrical connection, the fully assembled first connector housing 16, with the bus bars 70 provided therein, is positioned in some type of mounting fixture (not shown). The mounting fixture can be a standard type mounting fixture which is dimensioned to receive the first connector housing 16 therein. It is important that the mounting fixture be dimensioned to support the bus bars 70 is the housing, as the bus bars 70 are only positioned in the housing with an interference fit. The first connector housing 16 is positioned in the fixture such that the printed circuit board mating legs 58 and the circuit board mating pins 74 extend outward therefrom, in a manner similar to that shown in Figure 8.

With the first connector housing 16 properly positioned in the fixture, the first connector housing is moved into engagement with the first circuit board 12. In particular, the first connector housing is moved into engagement with the edge surface 220 of the board 12.

As the first connector housing 16 and the first circuit board 12 are moved into engagement, the printed circuit board mating legs 58 will engage the edge surface 220 of the first circuit board 12. It should be noted that the distance provided between the free ends of opposed mating legs 58 is less than the width of the first circuit board 12. Consequently, when the printed circuit board mating legs 58 first engage the board 12, the legs 58 will contact the edge surface 220. Upon further insertion of the first connector housing 16 onto the first circuit board 12, the legs 58 will be forced to spread apart and slide over the opposing side surfaces 212 of the board. This motion continues until the housing 16 is fully inserted onto the board 12, thereby positioning the legs 58 is electrical engagement with the conductive signal paths 210 provided on the board. The electrical engagement between the legs 58 and the paths 210 is ensured due to the legs are provided in a stressed position, and consequently provide a significant normal force between the legs and the paths.

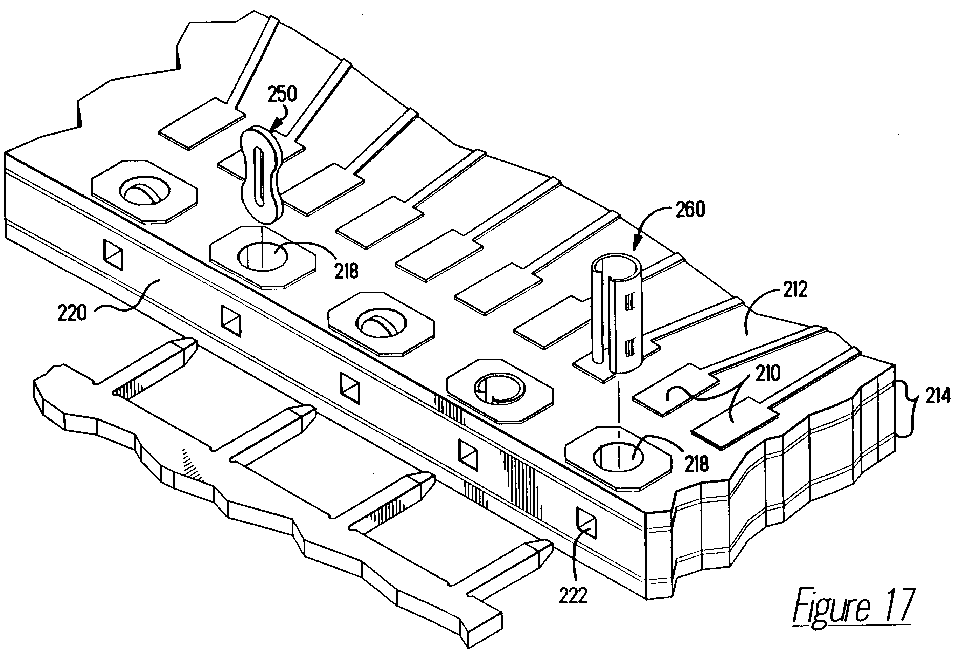

As the mating of the housing 16 with the board 12 occurs, the circuit board mating pins 74 also cooperate with the first circuit board 12. The pins 74 engage the edge surface 220 of the board after the printed circuit board mating legs 58 have begun sliding over the opposing side surfaces 212. It is important to note that the pins 74 must be provided in alignment with the openings 218 of the board 12 (as shown in Figure 17) as the mating occurs. In order to insert the pins 74 through the edge surface 220, the pins must exert a force on the side surface to allow the pins to penetrate the material of the circuit board. This force is generated by the fixture in which the first connector housing 16 is positioned. As the fixture maintains the bus bars 70 and the pins 74 in position relative to the housing, the insertion of the pins in the side surface of the board does not damage the bus bar or the housing.

As shown in Figure 17, the edge surface 220 of the first circuit board 12 can be prenotched to provide apertures 222 through which the pins 74 can be inserted. The prenotching reduces the insertion force required to position the pins 74 through the edge surface 220 of the board.

As the insertion of the pins through the edge surface 220 continues, the pins 74 enter into openings 218 through side walls 216 thereof. Referring to Figure 7, the insertion of the pins 74 is continued until the free ends of the pins 74 extend essentially across the openings 218. The openings illustrated in Figure 7 have plating provided on the side walls 216 thereof. As the pins are inserted through the side walls, the pins 74 cause the plating to be deformed, as is shown in Figure 7. This deformation provides a good electrical connection between the pins and the plating, and also enhances the mechanical retention of the pins in the openings.

With the first connector housing 16 fully inserted on the first circuit board 12, the printed circuit board mating legs 58 are soldered to the conductive signal paths 210, and the circuit board mating pins 74 are soldered in the openings 218. This provides the mechanical and electrical connections required between the first connector housing 16 and the first circuit board 12.

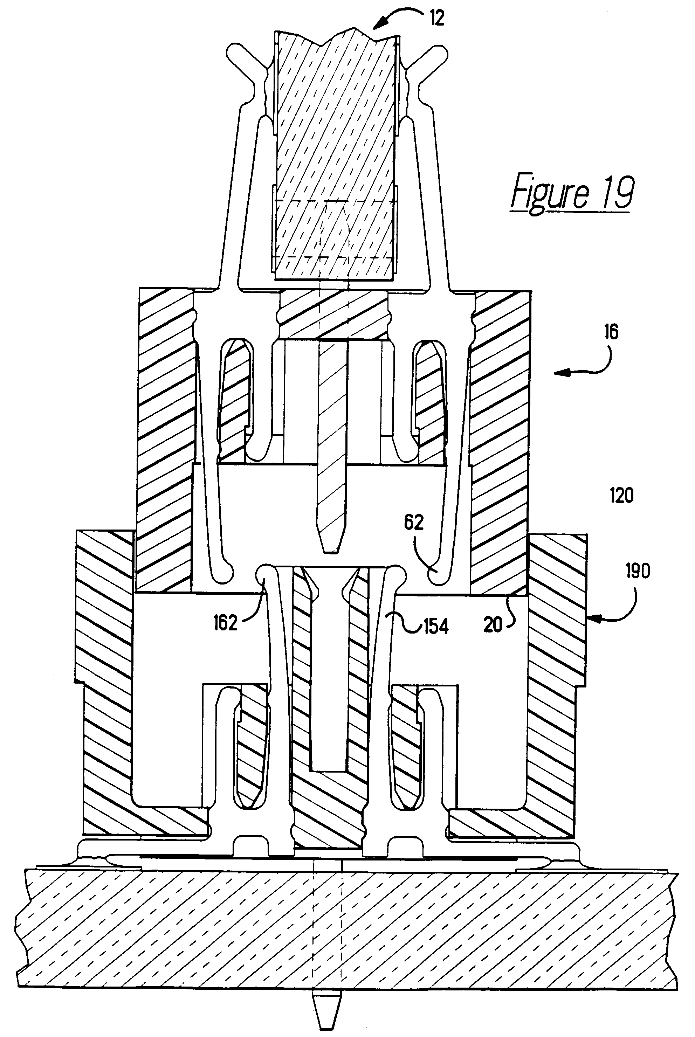

An alternative embodiment of the printed circuit board mating legs is shown in Figure 18. In this embodiment, the printed circuit board mating legs have grooves or pockets 80 provided thereon. As the mating legs are inserted, the legs cause the plating of the openings 218 to tear, as was previously described. However, in this embodiment, the grooves provide a channel between the end of the plating and the mating legs. As is shown in the figure, the grooves can extend to the end of the mating legs, or the grooves can be of shorter length. Consequently, when the mating pins are soldered in the openings, the solder will flow into the grooves and beyond the free ends of the plating, as shown in Figure 18, providing for a more reliable mechanical connection between the first circuit board and the first connector housing. It should be noted that the dimensioning of the grooves will vary depending upon the thickness and the ductility of the plating used in the opening. The grooves must be properly dimensioned to allow the plating to tear rather than conform to the opening.

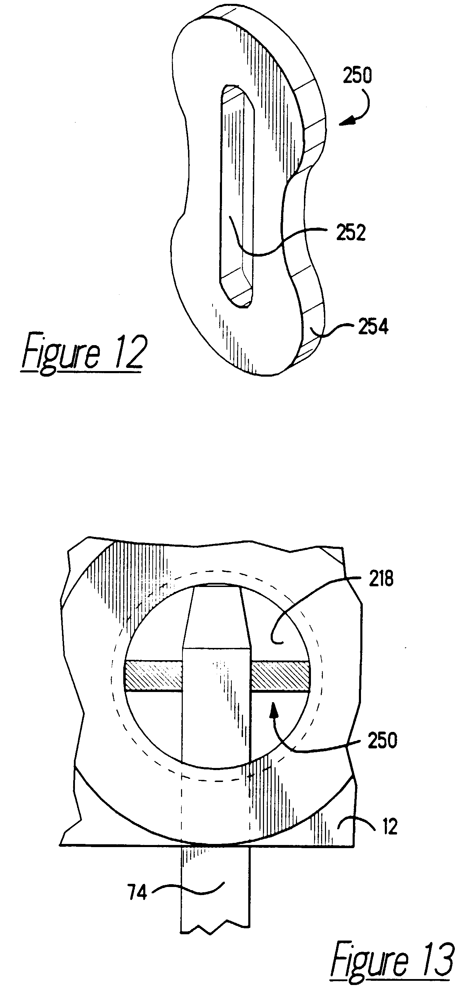

Referring to Figures 13 through 17, several alternate methods of maintaining the pins 74 in the openings 218 are shown. Figure 12 shows a first retention member 250 which can be used to retain the pins in the openings. The retention member 250 is inserted into the opening 218, as illustrated in Figure 17, prior to the mating of the first connector housing with the first circuit board. The insertion of the housing on the board is identical to that described above. However, when the pins are inserted into the openings, the pins will be inserted through openings 252 provided in the retention members, as shown in Figure 13. The retention members are dimensioned to ensure that a frictional engagement occurs between the side walls 216 of the openings 218 and the side surfaces 254 of the retention members. The openings 252 are dimensioned to ensure that a frictional engagement is provided between the pins 74 and the retention members 250. Consequently, the use of the retention members 250 in the openings 218 provides the mechanical and electrical connection required without the use of solder in the openings 218.

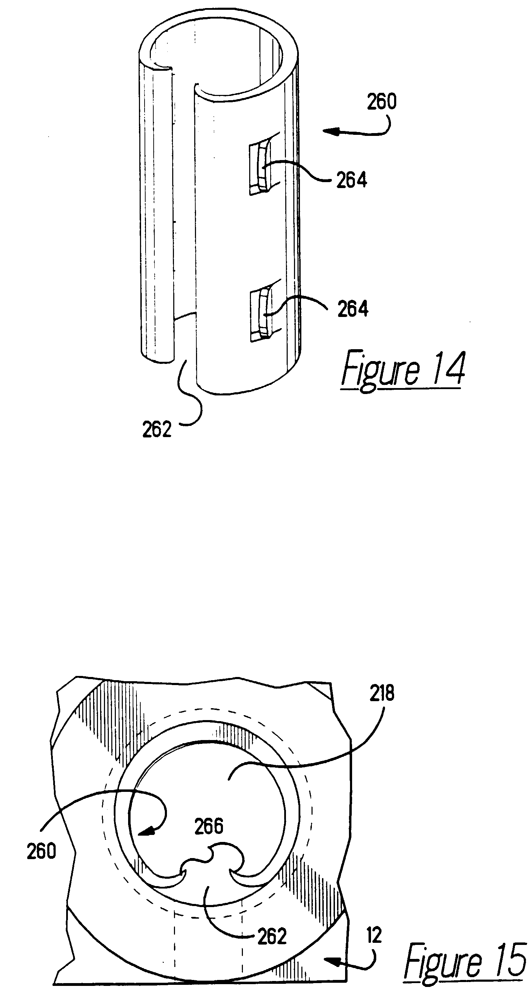

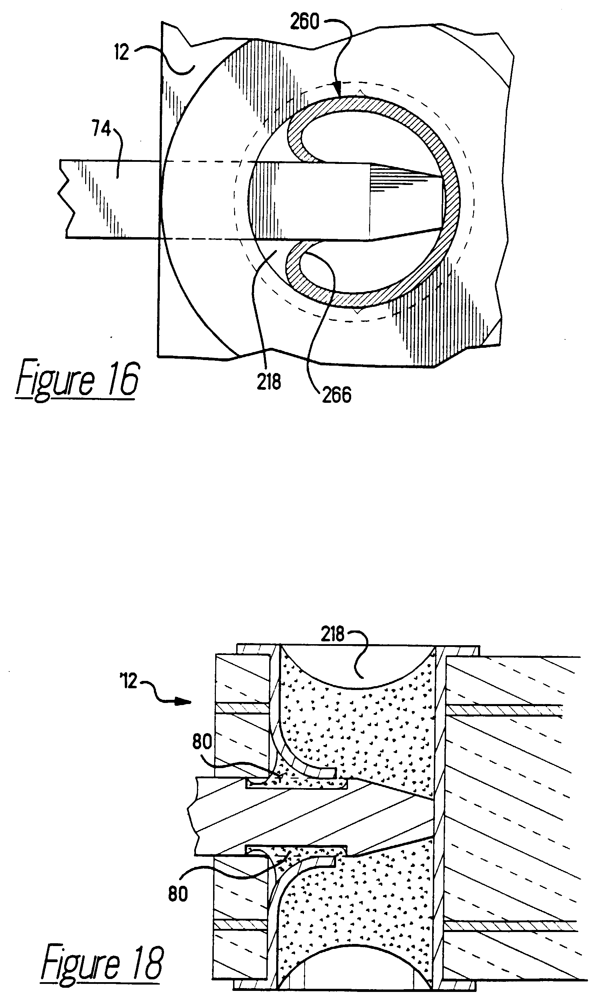

A second retention member 260 is shown in Figures 14 through 17. The second retention member 260 is cylindrical in shape. A slot 262 is provided along the length of the retention member 260. The retention member 260 is positioned in the opening 218, as shown in Figure 17. With the member 260 positioned in the opening, retention lances 264 (Figure 14) project into the side walls of the openings to provide the retention and electrical characteristics required between the member 260 and the side walls 216 of the openings 218. The pins 74 are then inserted into the openings 218, as shown in Figure 16, through the slots 262 of the retention members 260. Retention arms 266 behave as "Chinese fingers" to retain the pins in the openings. The retention arms also provide the electrical connection required between the members 260 and the pins 74, thereby eliminating the need for solder in the openings.

The are several advantages of utilizing a connector which is mounted onto the side surface of a circuit board. First, as the sophistication of equipment increases, more connectors are required to be positioned on circuit boards. As there is a limited amount of space available, solutions must be found to increase the amount of connectors mated to the circuit board. This invention allows the edges or side surfaces of the circuit board to be utilized for the mating of connectors thereto. Also, the placement of the connectors on the side surfaces of the circuit board allows for relatively short path lengths across which the signals travel, thereby minimizing the propagation delay associated with the connector.

With the insertion of the first connector housing 16 onto the first circuit board 12 complete, the fixture can be removed from the housing.

The second connector housing 18 is positioned on the second circuit board 14, as is illustrate in Figures 1 and 5 through 7. During this process, the circuit board mating pins 174 are inserted into the openings 238 provided on the circuit board 14. As the pins 174 are inserted into the openings 238, the printed circuit board mating legs 158 engage the conductive signal paths 230 provided on the surface 232 of the circuit board 230. The engagement of the legs 158 with the paths 230 defines the fully inserted position of the second connector housing relative to the second circuit board. With the second connector housing fully inserted, the pins 174 are soldered in the openings 238 and the legs 158 are soldered to the conductive paths 230. This provides the mechanical and electrical connection required between the second connector housing 18 and the second circuit board 14. The circuit board mating legs 58, 158 have arcuate surfaces provided at the ends thereof. The solder cooperates with the arcuate surface to provide the mechanical and electrical interconnection with the circuit boards. The configuration of the arcuate surfaces helps to insure that the solder will not crack. In other words, the use of mating legs which have flat surfaces promotes the solder to crack, thereby causing an unreliable connection.

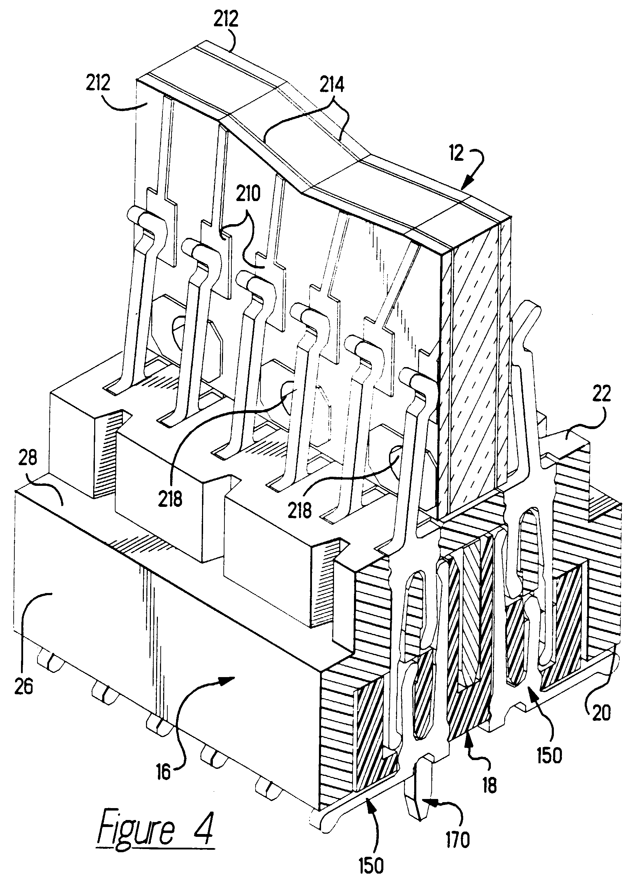

With the first and second connector housings 16, 18 properly mounted to the circuit boards 12, 14, the connector housings are mated together, as shown in Figures 4 through 7.

The first connector housing 16 is positioned proximate the second connector housing 18 such that the mating connector receiving recess 30 of the first housing is in alignment with the second connector housing. The mating connector receiving recess 30 is dimensioned to allow the second connector housing 18 to be inserted therein.

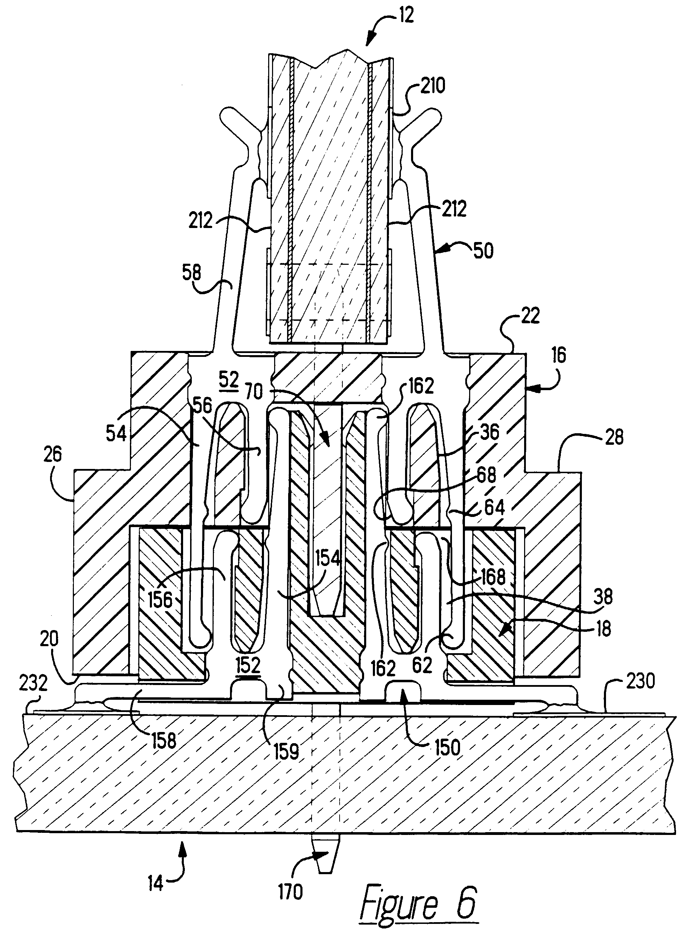

To mate the connector housings together, the first connector housing 16 is moved from the initial position shown in Figure 5 to the final or assembled position shown in Figure 6. As the connector housings are moved to the assemble position, the first connector terminals 50 engage the second connector terminals 150 to provide the electrical connection required.

As the mating occurs, the enlarged contact sections 62 of the first legs 54 of the first connector terminals 50 engage the lead-in surfaces 168 of the second legs 156 of the second connector terminals 150. At the same time, the enlarged contact sections 162 of the first legs 154 of the second connector terminals 150 engage the lead-in surfaces 68 of the second legs 56 of the first connector terminals 50.

The enlarged contact sectionss 62, 162 are then slide over the lead-in surfaces 168, 68, thereby positioning the enlarged contact sections 62, 162 on side surfaces of the second legs 156, 56. Several functions are performed by the lead-in surfaces. The lead-in surfaces compensate for any slight misalignment of the terminals when the mating occurs. The lead-in surfaces also cause the first legs 54, 154 to be moved to a stressed position, such that the enlarged contact sections 62, 162 will provide a significant normal force on the second legs 156, 56 when the contact sections are slide over the second legs.

As the mating of the connectors continues, the enlarged contact sections 62, 162 will be slid on the side surfaces of the second legs 156, 56 to the fully assembled position shown in Figure 6. This sliding engagement of the enlarged contact sections provides a wiping action under significant normal force conditions, thereby helping to ensure for a positive electrical connection between the enlarged contact sections 62, 162 and the second legs 156, 56. It should be noted that as the enlarged contact sections 62, 162 of the first legs 54, 154 are slid over second legs 156, 56, walls of the housings prevent the first legs 54, 154 from taking a permanent set. In other words, the walls of the housings are provided in close proximity to the first legs 54, 154, thereby insuring that the first legs can not be deformed beyond their elastic limit.

This type of terminal configuration allows for a connector which requires a minimal height for operation. As the entire length of the first legs 54, 154 are used for a resilient beam, the overall height of the connector can be minimized. In other words, the stationary portions of the terminals are provided on the second legs of the terminals, which is physically distinct from the first legs. Consequently, as no stationary portions are required on the first legs, the overall height of the first legs is minimized. It is also important to note that the second legs 56, 156 are used only as stationary members, i.e. no resilient characteristics are required. Consequently, the second legs can be secured in the housings and be used to stabilize the terminals in the housings.

The configuration of the terminals also provides for a reliable electrical connection. Each terminal provides two parallel paths over which the signal can travel. This provides for a redundant electrical connection, and results in a self inductance which is approximately half of that of a terminal with a single path. This is particularly advantageous in high speed applications.

As the connector housings are mated together, the bus bars 70 are positioned in the bus bar mating terminals 170, as shown in Figure 7. The spacing between the enlarged contact projections 176 of the bus bar mating terminals 170 is less than the width of the bus bars 70. Consequently, the positioning of the bus bars 70 in the bus bar mating terminals 170 causes the contact projections to be spread apart, which in turn causes contact projections 176 to exert the normal force required on the bus bars 70.

With the connector housing mated together, as shown in Figures 4 and 6, an effective electrical connection is provided between the first circuit board 12 and the second circuit board 14. The connection is provided utilizing minimal space, as the first connector housing is mated to the edge or side surface of the first circuit board. This is of great benefit, particularly as board real estate is at a premium.

An alternative embodiment of the housing is shown in Figure 19. In this embodiment the electrical connection provided between the first and the second circuit boards is performed in the same manner described above. However, in the embodiment shown in Figure 19, the second connector housing 18 has a shroud 190 which extends beyond the mating surface 120. The shroud 190 is dimensioned to be approximately the same height as the mating projection 130. The configuration of the shroud 190 protects the first legs 154 from being deformed prior to mating with the second legs 56 of the first connector housing 16. The shroud 190 also provides for the alignment of the connector housings when the housings are mated together. The shroud insures that the terminals will be in proper position prior to the engagement of the mating terminals, thereby preventing the terminals from being damaged during mating.

Although the connector assembly described provides an electrical connection between two printed circuit boards, the principal of the invention can be utilized in other types of connector assemblies, i.e a cable to board connector assembly.

## Claims

1. A connector assembly (10) in combination with a printed circuit board (12) having conductive pads (210), and conductive areas (218) provided therein, the connector assembly (10) having a housing (16) with first terminals (70) fixed thereto and extending therefrom, and having circuit board mating portions (74) cooperating with said conductive areas (218), which are proximate to the housing (16), the housing (16) having secured therein second terminals (50) having mounting portions (52) extending from the housing (16) and cooperating with said conductive pads (210) on the printed circuit board (12); characterised in that said pads (210) are provided on opposite major surfaces of the circuit board and said conductive areas (218) are spaced back from an edge surface (220) of the circuit board (12) adjacent to said opposite major surfaces; and in that the circuit board mating portions (74) of the first terminals (70) extend through said edge surface (220) of the printed circuit board (12) and through dielectric material thereof to reach and engage said conductive areas (218) of the circuit board (12).

2. A connector assembly (10) as claimed in claim 1, characterised in that the mounting portions (52) are resilient thereby insuring that the mounting portions (52) make electrical connection with the conductive pads (210) of the printed circuit board (12).

3. A connector assembly (10) as claimed in claim 1 or 2, characterised in that the circuit board mating portions (74) are rigid thereby insuring that the circuit board mating portions (74) make electrical connection with the conductive areas (218) of the printed circuit board (12).

4. A connector assembly (10) as claimed in claim 1, 2 or 3, characterised in that the conductive areas (218) are openings of the printed circuit board (12) which are positioned proximate the edge surface (220) of the printed circuit board (12).

5. A connector assembly (10) as claimed in any one of the preceding claims, characterised in that the mounting portions (52) and the circuit board mating portions (74) extend from a terminal receiving surface (22) of the housing (16) in a direction which is essentially perpendicular to the terminal receiving surface (22).

6. A connector assembly (10) as claimed in any one of the preceding claims, characterised in that the circuit board mating portions (74) have lead-in surfaces provided at free ends thereof, for cooperating with the edge surface (220) of the printed circuit board (12) to allow the circuit board mating portions (74) to be inserted through the edge surface (220) into the openings (218) of the printed circuit board (12).

7. A connector assembly (10) as claimed in claim 4, characterised in that the printed circuit board (12) has apertures (222) provided in the edge surface (220) thereof, which apertures (222) extend in a direction essentially perpendicular to the axis of the openings (218), the apertures (222) being dimensioned to receive the circuit board mating portions (74) of the first terminals (70) therein, such that the first terminals (70) extend through the apertures (222) into the openings (218).

8. A connector assembly (10) as claimed in claim 7, characterised in that the retention means (250,260) are provided in the openings (218), which cooperate with the circuit board mating portions (74) to maintain the circuit board mating portions (74) in the openings (218).

9. A connector assembly (10) having a housing (16) with first and second terminals (70,50) secured therein, each first terminal (70) being disposed centrally of the housing (16) and having contact portions (74) extending from the housing to free ends spaced from the housing and the second terminals (50) being disposed in rows to both sides of first terminals (70), the second terminals (50) converging toward first terminals (70) to arcuate mating portions (54) spaced from the housing and having convex contact surfaces disposed in two rows with the convex contact surfaces of each row being coplanar and facing portions (74) of the first terminals (70) and spaced therefrom, characterised in that:
said contact portions (74) of said first terminals (70) are pin contact sections, whereby the connector assembly is mountable to a circuit board edge with said second terminal convex contact surfaces adapted to be surface mounted to pads (210) of major surfaces (212) of a circuit board (12) and said pin contact sections being adapted to be inserted into an edge surface (220) of the circuit board for electrical connection to board contact portions (218) when the connector assembly is mounted astride an edge of the circuit board.

## Patentansprüche

1. Verbinderanordnung (10) in Kombination mit einer gedruckten Leiterplatte (12), die leitende Anschlußflächen (210) hat und in der leitende Bereiche (218) vorgesehen sind, wobei die Verbinderanordnung (10) ein Gehäuse (16) hat, an dem erste Anschlüsse (70) befestigt sind, die sich von diesem erstrecken, und mit Leiterplattenverbindungsabschnitten (74), die mit den leitenden Bereichen (218) zusammenwirken, die dem Gehäuse (16) benachbart sind, wobei in dem Gehäuse (16) zweite Anschlüsse (50) befestigt sind, die Befestigungsabschnitte (52) haben, die sich von dem Gehäuse (16) erstrecken und mit den leitenden Anschlußflächen (210) auf der gedruckten Leiterplatte (12) zusammenwirken;
**dadurch gekennzeichnet,** daß die Anschlußflächen (210) an entgegengesetzten Hauptoberflächen der Leiterplatte vorgesehen sind und daß die leitenden Bereiche (218) von einer Randoberfläche (220) der Leiterplatte (12) den entgegengesetzten Hauptoberflächen benachbart zurückversetzt angeordnet sind; und daß sich die Leiterplattenverbindungsabschnitte (74) der ersten Anschlüsse (70) durch die Randoberfläche (220) der gedruckten Leiterplatte (12) und durch dielektrisches Material davon erstrecken, um die leitenden Bereiche (218) der Leiterplatte (12) zu erreichen und zu ergreifen.

2. Verbinderanordnung (10) nach Anspruch 1, **dadurch gekennzeichnet,** daß die Befestigungsabschnitte (52) elastisch sind, wodurch sichergestellt wird, daß die Befestigungsabschnitte (52) eine elektrische Verbindung mit den leitenden Anschlußflächen (210) der gedruckten Leiterplatte (12) bilden.

3. Verbinderanordnung (10) nach Anspruch 1 oder 2, **dadurch gekennzeichnet,** daß die Leiterplattenverbindungsabschnitte (74) starr sind, wodurch sichergestellt wird, daß die Leiterplattenverbindungsabschnitte (74) eine elektrische Verbindung mit den leitenden Bereichen (218) der gedruckten Leiterplatte (12) bilden.

4. Verbinderanordnung (10) nach Anspruch 1, 2 oder 3, **dadurch gekennzeichnet,** daß die leitenden Bereiche (218) Öffnungen der gedruckten Leiterplatte (12) sind, die in der Nähe der Randoberfläche (220) der gedruckten Leiterplatte (12) angeordnet sind.

5. Verbinderanordnung (10) nach einem der vorhergehenden Ansprüche, **dadurch gekennzeichnet,** daß sich die Befestigungsabschnitte (52) und die Leiterplattenverbindungsabschnitte (74) von einer Anschlußaufnahmeoberfläche (22) des Gehäuses (16) in einer Richtung erstrecken, die im wesentlichen senkrecht zu der Anschlußaufahmeoberfläche (22) ist.

6. Verbinderanordnung (10) nach einem der vorhergehenden Ansprüche, **dadurch gekennzeichnet,** daß die Leiterplattenverbindungsabschnitte (74) an ihren freien Enden vorgesehene Einführungsoberflächen haben, um mit der Randoberfläche (220) der gedruckten Leiterplatte (12) zusammenzuwirken, um es den Leiterplattenverbindungsabschnitten (74) zu gestatten, daß sie durch die Randoberfläche (220) in die Öffnungen (218) der gedruckten Leiterplatte (12) eingesetzt werden.

7. Verbinderanordnung (10) nach Anspruch 4, **dadurch gekennzeichnet,** daß in der Randoberfläche (220) der gedruckten Leiterplatte (12) Öffnungen (222) vorgesehen sind, wobei sich die Öffnungen (222) in einer Richtung im wesentlichen senkrecht zu der Achse der Öffnungen (218) erstrecken, wobei die Öffnungen (222) so bemessen sind, daß sie die Leiterplattenverbindungsabschnitte (74) der ersten Anschlüsse (70) darin aufnehmen, so daß sich die ersten Anschlüsse (70) durch die Öffnungen (222) in die Öffnungen (218) erstrecken.

8. Verbinderanordnung (10) nach Anspruch 7, **dadurch gekennzeichnet,** daß Haltemittel (250, 260) in den Öffnungen (218) vorgesehen sind, die mit den Leiterplattenverbindungsabschnitten (74) zusammenwirken, um die Leiterplattenverbindungsabschnitte (74) in den Öffnungen (218) zu halten.

9. Verbinderanordnung (10) mit einem Gehäuse (16), in dem erste und zweite Anschlüsse (70, 50) befestigt sind, wobei jeder erste Anschluß (70) zentral in dem Gehäuse (16) angeordnet ist und Kontaktabschnitte (74) hat, die sich von dem Gehäuse zu freien Enden erstrecken, die von dem Gehäuse mit Abstand angeordnet sind, und wobei die zweiten Anschlüsse (50) in Reihen auf beiden Seiten der ersten Anschlüsse (70) angeordnet sind, wobei die zweiten Anschlüsse (50) zu den ersten Anschlüssen (70) zu gekrümmten Verbindungsabschnitten (54) hin konvergieren, die mit Abstand von dem Gehäuse angeordnet sind und konvexe Kontaktoberflächen haben, die in zwei Reihen angeordnet sind, wobei die konvexen Kontaktoberflächen jeder Reihe koplanar sind und zu den Abschnitten (74) der ersten Anschlüsse (70) hin gerichtet sind und von diesen mit Abstand angeordnet sind, **dadurch gekennzeichnet,** daß die Kontaktabschnitte (74) der ersten Anschlüsse (70) Stiftkontaktabschnitte sind, wodurch die Verbinderanordnung an einem Leiterplattenrand anbringbar ist, wobei die konvexen Kontaktoberflächen der zweiten Anschlüsse dafür ausgelegt sind, daß sie an Anschlußflächen (210) der Hauptoberflächen (212) einer Leiterplatte (12) an der Oberfläche angebracht werden, und wobei die Stiftkontaktabschnitte dafür ausgelegt sind, daß sie in eine Randoberfläche (220) der Leiterplatte für eine elektrische Verbindung mit Plattenkontaktabschnitten (218) eingesetzt werden, wenn die Verbinderanordnung reitend auf einem Rand der Leiterplatte angebracht wird.

## Revendications

1. Assemblage (10) de connecteur en combinaison avec une plaquette (12) à circuit imprimé ayant des plots conducteurs (210), et des zones conductrices (218) prévues à l'intérieur, l'assemblage de connecteur (10) ayant un boîtier (16) pourvu de premières bornes (70) fixées à ce boîtier et en faisant saillie, et ayant des parties (74) d'accouplement à la plaquette à circuit coopérant avec lesdites zones conductrices (218), qui sont proches du boîtier (16), le boîtier (16) ayant des secondes bornes (50) fixées dans ce boîtier et comportant des parties de montage (52) s'étendant depuis le boîtier (16) et coopérant avec lesdits plots conducteurs (210) sur la plaquette (12) à circuit imprimé ; caractérisé en ce que lesdits plots (210) sont situés sur des surfaces principales opposées de la plaquette à circuit et lesdites zones conductrices (218) sont espacées en arrière d'une surface (220) d'un bord de la plaquette (12) à circuit, à proximité immédiate desdites surfaces principales opposées ; en ce que les parties (74) des premières bornes (70), pour l'accouplement à une plaquette à circuit, s'étendent à travers ladite surface (220) du bord de la plaquette (12) à circuit imprimé et à travers une matière diélectrique de cette plaquette pour atteindre et engager lesdites zones conductrices (218) de la plaquette (12) à circuit.

2. Assemblage de connecteur (10) selon la revendication 1, caractérisé en ce que les parties de montage (52) sont élastiques de façon à assurer que les parties de montage (52) établissent une connexion électrique avec les plots conducteurs (210) de la plaquette (10) à circuit imprimé.

3. Assemblage (10) de connecteur selon la revendication 1 ou 2, caractérisé en ce que les parties (74) d'accouplement à une plaquette à circuit sont rigides afin d'assurer que les parties (74) d'accouplement à une plaquette à circuit établissent une connexion électrique avec les zones conductrices (218) de la plaquette (12) à circuit imprimé.

4. Assemblage (10) de connecteur selon la revendication 1, 2 ou 3, caractérisé en ce que les zones conductrices (218) sont des ouvertures de la plaquette (12) à circuit imprimé, qui sont situées à proximité de la surface (220) du bord de la plaquette (12) à circuit imprimé.

5. Assemblage (10) de connecteur selon l'une quelconque des revendications précédentes, caractérisé en ce que les parties de montage (52) et les parties (74) d'accouplement à une plaquette à circuit imprimé s'étendent depuis une surface (22) de réception de bornes du boîtier (16) dans une direction qui est essentiellement perpendiculaire à la surface (22) de réception de borne.

6. Assemblage (10) de connecteur selon l'une quelconque des revendications précédentes, caractérisé en ce que les parties (74) d'accouplement à une plaquette à circuit présentent des surfaces d'entrée situées à leurs extrémités libres, pour coopérer avec la surface (220) du bord de la plaquette (12) à circuit imprimé afin de permettre aux parties (74) d'accouplement à une plaquette à circuit d'être insérées à travers la surface (220) du bord dans les ouvertures (218) de la plaquette (12) à circuit imprimé.

7. Assemblage (10) de connecteur selon la revendication 4, caractérisé en ce que la plaquette (12) à circuit imprimé présente des ouvertures (222) situées dans la surface (220) de son bord, lesquelles ouvertures (222) s'étendent dans une direction essentiellement perpendiculaire à l'axe des ouvertures (218), les ouvertures (222) étant dimensionnées de façon à recevoir les parties (74) d'accouplement à une plaquette à circuit des premières bornes (70), afin que les premières bornes (70) s'étendent à travers les ouvertures (222) pour pénétrer dans les ouvertures (218).

8. Assemblage (10) de connecteur selon la revendication 7, caractérisé en ce que les moyens de retenue (250, 260) sont prévus dans les ouvertures (218), lesquels coopèrent avec les parties (74) d'accouplement à une plaquette à circuit pour maintenir les parties (74) d'accouplement à une plaquette à circuit dans les ouvertures (218).

9. Assemblage (10) de connecteur comportant un boîtier (16) ayant des première et seconde bornes (70, 50) fixées dans celui-ci, chaque première borne (70) étant disposée centralement au boîtier (16) et ayant des parties de contact (74) s'étendant depuis le boîtier jusqu'à des extrémités libres espacées du boîtier, et les secondes bornes (50) étant disposées en rangées sur les deux côtés des premières bornes (70), les secondes bornes (50) convergeant vers des premières bornes (70) jusqu'à des parties courbes (54) d'accouplement espacées du boîtier et ayant des surfaces convexes de contact disposées en deux rangées, les surfaces convexes de contact de chaque rangée étant coplanaires et faisant face, à distance, à des parties (74) des premières bornes (70), caractérisé en ce que :
lesdites parties de contact (74) desdites premières bornes (70) sont des tronçons de contact à broches, grâce à quoi l'assemblage du connecteur peut être monté sur un bord d'une plaquette à circuit, lesdites surfaces convexes de contact desdites secondes bornes étant destinées à un montage en surface sur des plots (210) de surfaces principales (212) d'une plaquette (12) à circuit et lesdits tronçons de contact à broche étant destinés à être insérés dans une surface (220) d'un bord de la plaquette à circuit pour une connexion électrique avec des parties (218) de contact de la plaquette lorsque l'assemblage de connecteur est monté à cheval sur un bord de la plaquette à circuit.
